# EUROPEAN PATENT APPLICATION

(11) **EP 1 847 844 A1**
(43) Date of publication of application: **24.10.2007**
(21) Application number: 06112943.3
(22) Date of filing: 21.04.2006
(51) Int. Cl.: G01R 31/319, G01R 13/34

(54) **Digital data signal analysis by evaluating sampled values in conjuction with signal bit values**

(71) Applicant: Agilent Technologies, Inc., Santa Clara, CA 95051 (US)
(72) Inventor: MOLL, Joachim, 71083, Herrenberg (DE)
(74) Representative: Barth, Daniel Mathias

(57) **Abstract**

The invention refers to determining time characteristics of a data signal (D1) comprising a sequence of a plurality of bits, comprising providing a first trigger signal (TR1, TR2) in response to a clock signal (CLK) related to the data signal (D1), providing first sample values (A1) from the data signal (D1), in response to the first trigger signal (TR1, TR2), and providing a signal analysis based on the first sample values (A1) in conjunction with bit values (B1, B2, B3) of the data signal in a certain time range with respect to the first trigger signal.

## Description

The present invention relates to sampling a digital data signal.

Characterizing the transient behavior of high-speed digital circuits, i.e. the transition from a logical zero to a logical one and vice versa, has become increasingly important for designing as well as manufacturing such digital circuits. Timing problems can cause single transmission errors, or temporary or even permanent outage of an entire communication system, and have to be avoided.

A standard characterization of digital circuits is the so-called Bit Error Ratio (BER), i.e. the ratio of erroneous bits to the total number of regarded bits. Therefore, a received digital data signal is repetitively sampled at defined sample points. Each sampling point is determined by a threshold value for comparing the response signal with an expected signal, and by a relative time (e.g. with respect to corresponding transition of a clock signal - usually the system clock for generating the stimulus signals or a clock signal derived therefrom or from the response signal).
A further technique of determining the characteristics of digital data signals is real time sampling or equivalent sampling of such signals by so-called sampling oscilloscopes. Thereby, samples are targeted at specific time delays with respect to a trigger signal. In order to determine the position of an edge within the signal, the signal value at such targeted time is determined and the position of the edge is determined by fitting the signal value to a predefined or acquired edge model. Such measurements can be determined by appropriate digital oscilloscopes, such as the Agilent 86100 Series digital sampling oscilloscopes provided by the applicant Agilent Technologies, the Agilent 86100 Series oscilloscopes being able for sampling high speed digital data signals having edges with rise and fall times below 20 picoseconds.

### DISCLOSURE OF THE INVENTION

It is an object of the invention to provide an improved sampling of a digital data signal. The object is solved by the independent claims. Preferred embodiments are shown by the dependent claims.

According to embodiments of the present invention, a signal analyzer is provided for determining a digital edge or transition timing of a digital data signal, the digital data signal comprising a sequence of a plurality of bits. The data signal might be provided by a device under test -DUT- that is to be tested according to specifications. The invention is based on the insight that signal edges in high speed digital signals show significant durations of transition. The knowledge of an edge shape allows for sampling the signal once in such transition area and fitting the sampled value to the known edge shape in order to exactly timely locate the edge. Incorporating such analyzer into an under-sampling oscilloscope (i.e. into an oscilloscope having a sampling below the data rate of the sampled signals) allows exactly determining timings of signal edges.

Therefore, the analyzer keeps stored, produces or accesses one or more edge models (e.g. a unique edge model, if the rising edge and the inverted falling edge are similar, each a rising edge model and a falling edge model otherwise, or multiple edge models for different bit histories) for characterizing signal transitions between the digital magnitude levels (low level and high level) of the data signal. The edge model describes the expected signal value over the time of the data signal. Fitting the said edge model the detected signal value, the difference in magnitude between said detected signal value and a timing reference value or predefined edge value, wherein the predefined edge value might e.g. represent the edge center magnitudes at a 50% magnitude level between the low level and the high level or the mid-time between the beginning of the edge and the end of the edge, is transformed into a time difference value. By relating the time difference value to the trigger signal, the exact position of the signal edge can be determined.

The timing reference value of the edge model can be any value between the low level and the high level, e.g. the 50% level in the middle between those levels, or in the geometric center of the edge model and/or the most likely transition point.

The edge model might be determined as a polynomial best fit curve of a measured signal edge. The edge model might be represented as section-wise curve composed of one or more linear or polynomial sections. Thereby, the edge model might be stored as mathematical formula or algorithm producing a time value out of an signal value, a table comprising a plurality of pairs of curve values and time values of said edge model, or as any mixture between algorithms and data.

In an embodiment, the analyzer comprises an analog sampling circuit for taking first sample values from the data signal in response to a first trigger signal showing a plurality trigger pulses preferably located in edge regions, also referred to as transition regions, of the data signal, a trigger circuit for providing the first trigger signal in response to a clock signal related to the data signal, and an analyzing circuit for providing a signal analysis based on the sample values received from the first sampling circuit in conjunction with bit values of the data signal in a certain time range with respect to the first trigger signal.

Preferably, the sampling time points are determined according to the clock signal relating to the data signal. Thereby, the time points are chosen such that they are close to the defined edge points, but at least in an edge region showing a significant signal value change over time.

If the bit values are known in advance, the bit values might be directly received from a memory having stored the bit values. Alternatively, the signal analyzer further comprises a digital sampling circuit for detecting the bit sequence. The digital sampling circuit samples the data signal, preferably in the bit center region, i.e. in the center of the data eye of the data signal, i.e. in a region between signal transitions, at a plurality of subsequent second trigger time points, reproduces a bit sequence of the data signal, and provides these second values to the analyzing circuit. The analyzing circuit provides a signal analysis based on both first and second values.

With the digital sampling circuit a number second values representing a number of preceding bits relative to a transition (bit history) and (at least one) following bit(s) are stored together with the first value representing the transition value sampled by the analog sampling circuit.

In further embodiment, the bit sequence of the data signal is determined by comparing the data signal with a threshold, assigning one of two bit values depending on the comparison result (e.g. a "0" value, if the comparison result is negative and a "1" value if the comparison result is positive) at successive trigger points.

Therefore, a second sampling circuit is provided for receiving a second trigger signal in response to the clock signal, comparing the data signal at the trigger points of the second trigger signal with the threshold. The trigger pulses of the second trigger signal are preferably located within regions between signal transitions, substantially in the middle of a so-called data eye.

In a further embodiment the analog sampling circuit comprises a sample&hold circuit (or a track&hold circuit), and an analog-to-digital converter. The sample&hold circuit receives first trigger signals and provides each an analog value (e.g. an analog voltage) of the data signal at a corresponding first trigger times and keeps this values each stored for a certain amount of time. The analog-to digital converter converts the received analog value into a multi bit digital value, e.g. being represented as 12 bit data or 16 bit data.

In a further embodiment, the measurement of time differences is repeated for a plurality of edges. If the data signal comprises a multiple repetition of a test sequence, e.g. a 1000-time repetition of a defined bit pattern, wherein the bit pattern might be a pseudo random bit sequence generated by a linear feedback shift register circuit or any other pattern containing a plurality of frequency components and therewith suitable for timing test purposes.

From these measurements, jitter characteristics of the data signal can be derived. If only measurements of bit time intervals having the same bit history, e.g. of the bit intervals at each the same position within the repeated bit pattern are performed, such mean value difference denotes the jitter components excluding data dependent jitter.

In a further embodiment, the data signal is analyzed with respect to a depth of influence of previous bits to an actual transition, or in other words with respect to the influence of the bit history. This influence can be denoted as number of preceding bits. The sequences of a defined number of digital values provided by the digital sampling circuit are collected with respect to the transitions to be analyzed, i.e. each first (multi-bit) sample value is assigned to a certain sequence of second sample (single bit values), also being referred to as bit history.

In order to determine a number of preceding subsequent bits influencing an actual transition, i.e. to determine a depth of influence of previous bits to an actual transition, sampled values of repetitive measurements are sorted or binned according to their bit history, e.g. binned to eight different groups each related to one history of a three bit sequence. Such binning is further extended to longer history as long as they show different mean values with respect to the clock signal.

In a further embodiment, a signal analysis is carried out for determining non data dependent jitter characteristics by generating trigger signals on the condition that a defined history, i.e. a defined bit sequence of the data signal is being detected.

If the influence is found to be limited to a number of n bits, a determination of jitter excluding data depending jitter might be carried out by detecting a certain sequence n bits and triggering on each occurrence of this pattern. This is in particular advantageous, if long bit sequences are used, where an analysis of every edge position would take too long.

Alternatively, the sampling might be performed at random timing points, whereby the first sample values (representing the actual edge value) and the second sample values (representing the bits of the data signal) are stored with relation to each other. In a post processing the first sample values are sorted with respect to a certain number of preceding bits into different bins.

In a further embodiment, the analyzing circuit comprises a processing unit for storing the one or more edge models in terms of digital values, e.g. arranged in tables of time/signal value pairs, or in terms of an algorithm providing digital values. Therewith, the above-described time differences are determined by a digital calculation of the computer. Such models and algorithms might be stored in for of software programs.

In a further embodiment, a time interval analysis between edges (e.g. between a rising edge and an adjacent falling edge of a digital data signal, a rising edge and an non-adjacent falling edge, two rising edges, two falling edges, or two edges of each a different data signal) is provided, whereby for each signal edge a sample value is taken. Therefore, a first time difference between a first signal sample and the defined signal value and a second time difference between a second signal sample and the defined signal value is determined. The time interval between the edges can be determined on the base of the known time difference of the corresponding trigger pulses and the first and second time differences.

In a further embodiment, the measurement of time differences is repeated for a plurality of similar time intervals, e.g. for a fraction of a bit cycle in the case of determining variations of return-to-zero time intervals, one bit cycle in the case of determining cycle-to-cycle time variations or a plurality of bit cycles for determining variations of a plurality of bit cycles. If the data signal comprises a multiple repetition of a test sequence, e.g. a 1000-time repetition of a defined bit pattern, wherein the bit pattern might be a pseudo random bit sequence generated by a linear feedback shift register circuit or any other pattern containing a plurality of frequency components and therewith suitable for timing test purposes.

From these measurements, jitter characteristics of the data signal can be derived. A first jitter property can be derived by determining each a distribution function over the time of the first and second time differences, determining each the mean value, and determining the difference between both mean values.

If only measurements of bit time intervals having the same bit history, e.g. of the bit intervals at each the same position within the repeated bit pattern are performed, such mean value difference denotes the jitter components excluding data dependent jitter. A further jitter component can be derived by determining a distribution function of the differences of the second time difference and the first time difference over the time. If such a distribution is determined for all bit cycles (or n-bit cycles) of the data signal, the widths of such distribution (i.e. the minimum and maximum values) denotes an overall cycle-to-cycle jitter including data dependent jitter and random jitter. If such distribution is performed for bit time intervals having the same bit history, such widths denotes random and periodic cycle-to-cycle jitter.

In a further embodiment, the analyzing circuit comprises a processing unit for storing the one or more edge models in terms of digital values, e.g. arranged in tables of time/signal value pairs, or in terms of an algorithm providing digital values. Therewith, the above-described time differences are determined by a digital calculation of the computer. Such models and algorithms might be stored in for of software programs.

One limitation of the above-described method is that the trigger time points must be chosen to trigger the signal with transition areas, as otherwise it might not be possible to perform a value fitting to the stored modes. In order to enhance the trigger time range, where trigger signal can be placed, the time width of the transition areas, i.e. the transition time, might be increased. Therefore, a filter showing a linear phase response might be connected between a data input and the sampling circuit. This filter decreases the (absolute) gradient of the signal edges without influencing the jitter properties of the data signal.

In a further embodiment, the trigger time interval measurement range is extended by placing a plurality of trigger signals at a defined distance to each other. The distance is preferably chosen to be equal to a measurement or trigger time range of a single transition. This allows for multiplying the resulting measurement range by the number of trigger signals.

In a further embodiment, an extended sampling circuit is provided comprising a plurality of sampling paths, each comprising a sample&hold circuit and an analog-to-digital converter. A data signal to be sampled is provided to each one sample&hold circuit. Further, a trigger control circuit is provided for generating a plurality of subsequent trigger signals in response to a clock signal. The trigger signals are provided to each a trigger input of the sample&hold circuits. The outputs of the sample&hold circuits are connected to each one of the analog-to-digital converters. The corresponding digital values generated by the analog-to-digital converters are provided to an analyzing circuit that might chose the most significant value (i.e. the value not close or equal to the "low" or "high" signal level) for further edge fitting.

Alternatively, the extended digital trigger circuit might comprise only one sampling path comprising a sample&hold circuit and an analog-to-digital converter. The data signal to be sampled is provided to the sample&hold circuit. Further, a trigger control circuit is provided for generating a plurality of subsequent trigger signals in response to a clock signal. The trigger signals are provided to the sample&hold circuit. The sample&hold circuit generated a plurality of analog sample values in response to each trigger signal. These trigger signal might be provided to one analog-to-digital converter or to a plurality of analog-to-digital converters, e.g. being subsequently switched to the output of the sample&hold circuit by means of fast switchable transfer gates. Similarly to the previous embodiment, the analyzing circuit receives the analog values for further processing.

In a further embodiment, a time interval analyzer for sampling two signal edges of interest in order to derive a time interval between said edges might apply for each edge sampling an extended measurement as described before. Therefore, e.g. for duplicating the measurement range, four corresponding trigger signals are provided to one or a plurality of sample&hold circuits. The analyzing circuit receiving four analog values first might chose for each edge one value to be further processed. From the selected values, a first time difference and a second time difference between the might be determined as described above.

Alternatively, the sample&hold circuits of the above embodiments might be replaced by so-called track&hold circuits.

Embodiments of the invention can be partly or entirely embodied or supported by one or more suitable software programs, which can be stored on or otherwise provided by any kind of data carrier, and which might be executed in or by any suitable data processing unit.

### BRIEF DESCRIPTION OF DRAWINGS

Other objects and many of the attendant advantages of embodiments of the present invention will be readily appreciated and become better understood by reference to the following more detailed description of embodiments in connection with the accompanied drawing(s). Features that are substantially or functionally equal or similar will be referred to by the same reference sign(s).

Fig.1 shows a schematic block diagram of a sampling device comprising a digital sampling path and an analog sampling path according to an embodiment of the invention,

Fig. 2a shows a diagram with a fraction of an first exemplary data signal over the time with exemplary time measurement values relating to a time interval between two adjacent signal edges,

Fig. 2b shows a diagram with fraction of a second exemplary data signal over the time with exemplary time measurement values between signal edges at a distant of a plurality of clock cycles,

Fig. 3a shows a schematic diagram with a distribution of rising edge times and falling edge times of repeated measurements at each one bit with the same bit history,

Fig. 3b shows a schematic diagram with a distribution of resulting cycle times of the measurement of Fig.3a,

Fig.4 shows a tree diagram with different hierarchies of bit history to a rising edge being collected in different bins and exemplary time distributions of different bins,

Fig.5a shows a schematic block diagram of a sampling device with an enhanced measurement range according to a further embodiment of the invention,

Fig.5b shows an exemplary sampling diagram pertaining to Fig.5a,

Fig. 6a shows a more detailed block diagram of the time interval analyzer according to Fig.1a or Fig.1b comprising a digital sampling path according to Fig.3,

Fig. 6b shows a variant of Fig.6a with two analog-to digital converters,

Fig.6c shows a variant of Fig.6b with a sampling circuit comprising three sample&hold circuits, and

Fig.7 shows schematic diagrams describing a jitter separation with bit history consideration

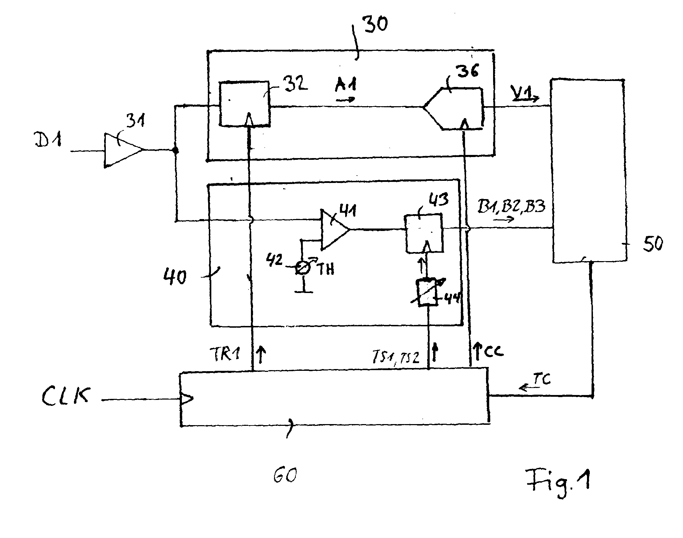

Fig. 1 shows a block diagram of a signal analyzer comprising an input buffer 31 and providing an input data signal D1 to an analog sampling path 30 and a digital sampling path 40. The analog sampling path 30 comprises a first sample&hold circuit 32, further also referred to as analog value sample&hold circuit 32 and an analog-to digital converter 33. The output of the sample&hold circuit 32 is connected to the input of the analog-to digital converter 36. The output of the analog-to digital converter 33 is connected to a first input of a signal analyzing circuit 50. Further, a trigger circuit 60 is provided that receives a clock signal CLK from a source not shown here, e.g. provided by a data source providing a digital data signal D1 recovered form the data signal D1 or being generated by an independent clock , and an trigger control signals TC from the analyzing circuit 50. The trigger circuit 60 provides a first trigger pulse TR1 to the trigger input of the sample&hold circuit 32 and further provides a converter trigger pulse or control signal CC to the analog-to-digital converter 33, whereby the time distance between those trigger signals is selected according to capabilities of holding a captured value over time of the sample&hold circuit 32.

The data signal D1 to be analyzed is provided to the input buffer 31 that provides a correspondingly buffered signal to the data input of the sample&hold circuit 32 that samples the actual data signal value A1 at the time point of receiving the first trigger pulse TR1. This analog value, that might be represented as an analog voltage within a certain voltage range is kept stored for a certain amount of time. The analog-to digital converter 33 converts the received analog value into a multi-bit digital value, e.g. being represented as 12 bit data or 16 bit data V1. This digital data value is provided to the analyzing circuit 50 for further edge fitting as described above.

The analyzing circuit 50 keeps stored one or a plurality of edge models for characterizing a signal edge, e.g. rising edge or a falling edge between the digital magnitude levels of the data signal. The edge model describes the expected signal value over the time of the data signal D1. Such edge models might be stored in form of a plurality of (multi-bit) digital data (e.g. 12 bit data or 16 bit data) with a certain time resolution. Alternatively, the edge model can be stored e.g. as polynomial best fit curve of a most likely edge or a (time or magnitude) section-wise curve composed of one or more linear or polynomial sections. The data might be stored in a memory or data base being part of or being accessible by the time interval analyzer.

By fitting said edge model and the detected signal to each other, the difference in magnitude between said detected signal values and predefined signal values, can be, are transformed into time difference values. By way of example the predefined signal value is the center values at a 50% level between the "low" bit signal level and a "high" bit signal level. By relating the time difference value to the clock signal, the exact position of the signal edge can be determined.

Further, a digital sampling path 40, also being referred to as bit history determination path, is provided for taking a plurality of second sample values from the data signal D1 at a plurality of subsequent digital path trigger time points TD1-TD3, whereby these trigger points are preferably placed at equidistant time points within each the bit center of the data signal, i.e. these trigger points being placed in the center of the data eye.

Therefore, the analyzing circuit further comprises a comparator 41, a tunable threshold voltage source 42, a sampling flip flop (or digital sample&hold circuit) 43, and a tunable time delay circuit 44. A first input of the comparator 41 is connected to the buffer 32 for receiving the (buffered) data signal D1, whereas a second input of the comparator 41 is connected to the tunable threshold voltage source 42 that provides a tunable threshold voltage TH to said input. The output of the comparator 41 is connected to the data input of the sampling flip flop 43. The output of the sampling flip flop 43 is provided to the data analyzing circuit 50. The trigger input of said sampling flip flop 43 is connected to the tunable time delay circuit 44 that receives the clock signal CLK and provides a correspondingly delayed clock signal to the trigger input of the sampling flip flop 43. The clock signal CLK is preferably delayed such that the digital path trigger points are placed in the center of the data eye of the digital data signal D1.

The comparator 41 compares the digital data signal D1 with a constant threshold TH (e.g. the mean between the low signal level representing a bit value of "0" and the high signal level representing a bit value of "1", also being referred to as 50% level), or a dynamic threshold as e.g. applied in so-called decision feedback equalization (DFE). The comparator 41 generates a first value (e.g. a low voltage level), if the corresponding comparison value is below the threshold and a second value (e.g. a high voltage level"1", if the comparison value is above the threshold TH.

The sampling flip flop 43 samples the comparison result each at the digital path trigger points and assigns digital time discrete comparison results B1-B3 that are provided as bit stream to the analyzing circuit 50.

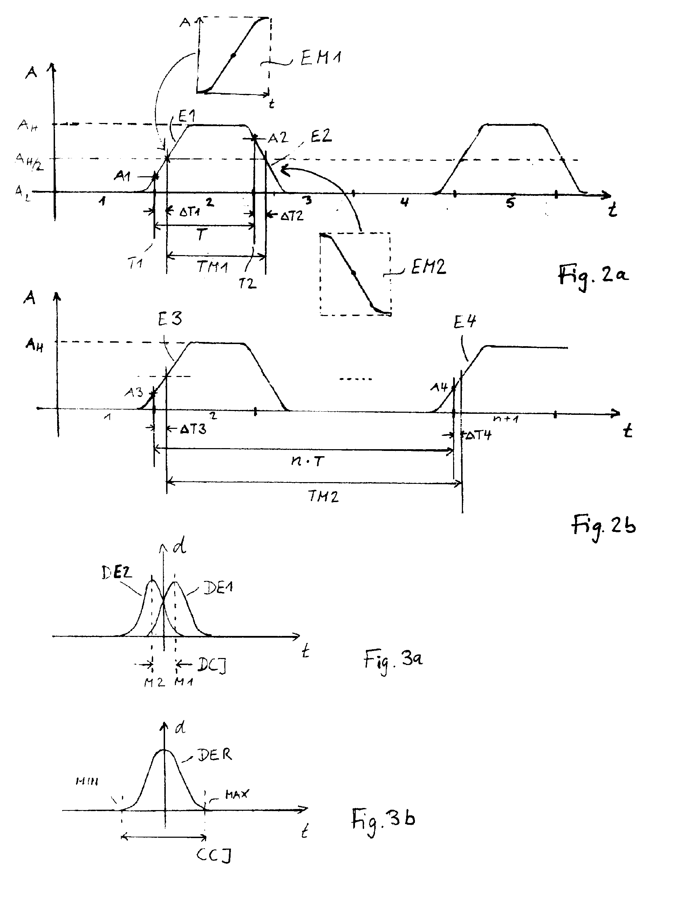

In an embodiment, the analyzing circuit 50 might continuously analyze the received bit stream B1, B2, B3 for detecting a predefined bit sequence within this bit stream. As soon as such predefined bit stream is detected, the analyzing circuit 50 generates a feed-back information FI to the trigger circuit 60. The trigger circuit 60 then provides a trigger pulse TR1 at the next possible signal transition. The correspondingly derived digital values V1 all have the same defined bit history. If such values are collected a plurality of times and corresponding time delays are superimposed as e.g. described above under Fig.3a, non data dependent jitter might be determined, provided that the length of the bit history is long enough to cover for history influences. The number of bits to be part of the bit history might be a fixed number or a selectable number being selected by the user.

Alternatively, the sampling might be performed at random timing points, whereby the first sample values (representing the actual edge value) and the second sample values (representing the bits of the data signal) are stored with relation to each other. In a post processing the first sample values are sorted with respect to a certain number of preceding bits into different bins.

In a further embodiment, the signal analyzer automatically determines the number of bits according to the history characteristics of the data signal D1.

In order to determine a number of preceding subsequent bits influencing an actual transition, i.e. to determine a depth of influence of previous bits to an actual transition, the analyzer is adapted for continuously determining transition values V1 of all bit transitions or a subset of bit transitions (e.g. all rising edges within one test sequence) of the data signal D1). At the same time the digital bit sequence B1, B2, B3 being received from the sample flip flop 43 is received and related to the transition values V1. The analyzing circuit 50 might then (in a post processing step) assign to each sample value V1 being sampled in the analog path a defined number of preceding bits B1, B2, B3, being sampled in the digital path.

Alternatively, if the bit sequence of the data signal D1 is known, or in other words, if the data signal D1 is known in principle, such sequence might be assigned to the sampled values V1 directly without digital sampling.

Further alternatively the sampled digital sequence might be used for synchronizing, i.e. for detecting a match of the sampled digital sequence with a sequence part of the known data signal D1, and performing a time relation with the analog sampling circuit. Therefore the analyzing circuit 50 might provide trigger control signals TC to the trigger circuit 60.

For measuring jitter characteristics without data dependent jitter, i.e. without any bit history influence, it is possible to provide a data signal with a repetitive bit sequence and to repetitively trigger this signal each at the same positions relative to each bit sequence. As this method only allows for only one measurement per repetition, the overall measurement time will increase with the length of the bit sequence. As it is often necessary or at least desirable to have short test times, this method only allows for short bit sequences, e.g. a Pseudo Random Bit Sequence PRBS with a degree of 15 bit corresponding to an example above-described.

The influence of previous bits to an actual bit might result from low pass characteristics of the DUT circuitry, e.g. internal transmission lines, amplifier output stages, etc. Depending on the lengths, specific characteristics of the transmission line, and the data speed, such influence is limited in time, or in other words, only a limited number of previous bits will have effects on an actual data signal value.

Therefore, in a further embodiment, the data signal is analyzed with respect to a depth of influence of previous bits to an actual bit, or in other words with respect to the influence of the bit history. This depth of influence can be denoted as number of preceding bits. For determining non data dependent jitter, the data signal will be triggered at a plurality of transitions having the same limited bit history, e.g. having the same preceding m-bit sequence, wherein m denotes the depth of influence. This allows for using long repetitive test patterns without increasing the test time. Further this allows for using non-repetitive data signals.

Alternatively, the analog sampling might be performed at timing points not being related to the data content (i.e. the bit sequence) of the data signal, preferably at equidistant time points, whereby the distance might be chosen to greater or equal the conversion time of the analog-to-digital converter(s) (e.g. a distance of 200 bit cycles of the data signal). The corresponding first sample values V1 and V2 and second sample values B1, B2, B3,..., are stored with relation to each other in or by the analyzing circuit 50. In a post processing, the first sample values are sorted with respect to their bit history into different bins.

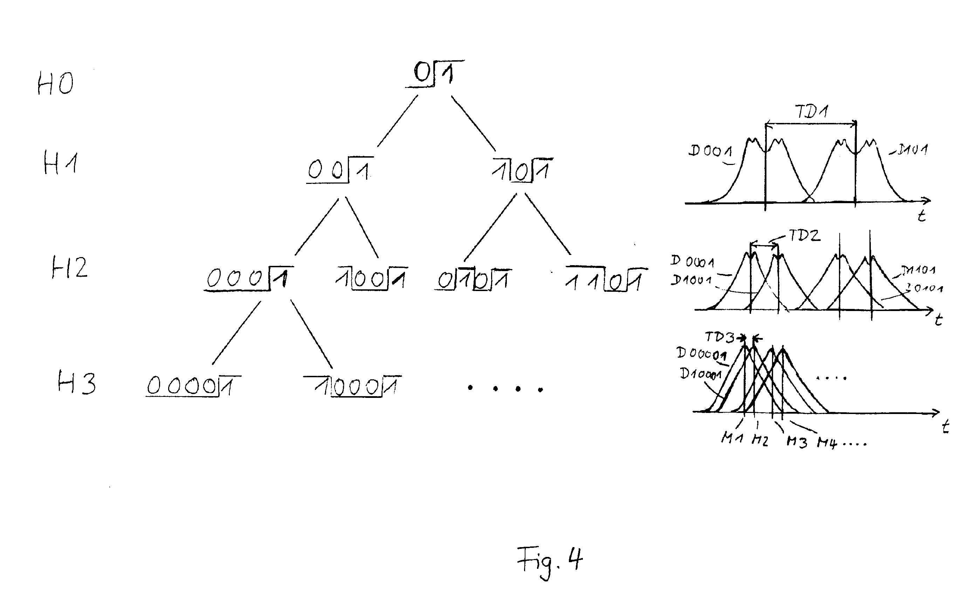

Fig.4 shows a principle scheme for determining the number of bits being relevant as bit history. In the first row H0 on the left side, a bit sequence of two bits "01" showing a transition with a rising edge, i.e. a transition from "0" to "1" is shown. In the second row, also being referred to as first history level H1, on the left side, 2 bit sequences of three bits, "001" and "101" are shown. The first sequence "001" of this level equals the sequence "01" of the row above together with a preceding bit "0". The second sequence "101" of this level equals the sequence "01" of the row above together with a preceding bit "1". On the right side of this level, for each of these sequences, a distribution of edge times D001 and D101 with respect to a clock signal as result of a plurality on measurements is shown. The difference of the mean values of both distributions D001 and D101 is depicted as first time distance TD1. This time distance indicates the dependency of first preceding bit on the edge timing of the data signal D1.

In the third row, also being referred to as second history level H2, on the left side, 4 bit sequences of four bits, "0001", "1001", "0101" and "1101" are shown. The first sequence "0001" of this level equals the first sequence "001" of the row above together with a preceding bit "0". The second sequence "1001" of this level equals the sequence "001" of the row above together with a preceding bit "1". The third sequence "0101" of this level equals the second sequence "101" of the row above together with a preceding bit "0". The fourth sequence "1101" of this level equals the second sequence "101" of the row above together with a preceding bit "1". On the right side of this level, distributions D0001, D1001, D0101 and D1101 of the edge times for the four different histories with respect to a reference signal as result of a plurality on measurements are shown. The difference of the mean values of the distributions D0001 and D1001 is depicted as second time distance TD2. This time difference indicates the dependency of the second preceding bit on the edge timing of the data signal D1. As qualitatively depicted this time distance TD2 is smaller than the first time distance TD1. For completeness reason, it is mentioned that the same measurement of time difference might be carried out for the third and the fourth sequence.

In the fourth row, also being referred to as third history level H3, on the left side, exemplary 2 bit sequences out of 8 sequences comprising 5 bits, "00001", "10001" are shown. The first sequence "00001" of this level equals the first sequence "0001" of the row above together with a preceding bit "0". The second sequence "10001" of this level equals the first sequence "0001" of the row above together with a preceding bit "1". On the right side of this level, exemplary for the shown first two sequences of this row, the first four distributions D00001 D10001, D01001, and D11001, of the edge times for the corresponding histories with respect to a time reference as result of a plurality on measurements are shown. The difference of the mean values of both distributions is depicted as third time distance TD3. This time difference indicates the dependency of the third preceding bit on the edge timing of the data signal D1. As qualitatively depicted this time distance TD3 is smaller than the second time distance TD2. Again for completeness reason, it is mentioned that the same measurement of time difference might be carried out for the third and the fourth, the fifth and sixth, and the seventh and eighth sequence not shown here.

As result of the history separation of the fourth history level, mean edge times M1, M2, M3, M4,.., are obtained as mean values of the corresponding edge time distributions.

A simple algorithm for determining the depth of bit history might thus proceed as follows:

In a first measurement run, a certain number of transitions measurements (e.g. 1024 samples) are performed. The corresponding timing results are sorted in separate bins in dependence of their bit history. On the first history level, the timing results are binned in dependence of the value of the first preceding bit. Therewith, the measured samples are sorted into two bins 001 and 101. For each bin, the mean values of the distributions are determined and the corresponding first time distance TD1 is compared with a predefined (sufficiently small) maximum time. If the first time distance TD1 does not exceed the predefined maximum time, the depth of influence is expected to be one bit. Otherwise, if the first time distance TD1 exceeds the predefined maximum time, the timing results are sorted into four bins 0001, 1001, 0101 and 1101 of the second history level H2. Again, the second time distance TD2 between two mean values (e.g. the mean values of the bins 0001, 1001) originating from one bin of the above level (e.g. bin 001), (and/or from the mean values of the bins 0101 and 1101) of this level is compared with the predefined maximum time. If the second time distance TD2 now does not exceed the predefined maximum time, the depth of influence is expected to be two bit. Otherwise this algorithm is continued in the same manner for further history levels.

Due to the limited number of measurement obtained the first run, the number of bins for sorting the measurement values is limited, because a sufficient number of results is necessary for obtaining relevant distributions for the corresponding edge timings. (E.g. for 1024 measurement values, the algorithm might stop at the third history level, wherein each bin will have 128 measurement values at average.) If the corresponding time difference is found to exceed the predefined maximum time at a certain history level (e.g. the third history level H2 for 1024 values), another set of measurements might be obtained in a second measurement run (e.g. again 1024 measurement values) in order to provide a sufficient number of values for further sorting. The second measurement run can be carried out in parallel to the (post-processing) history level evaluation algorithm.

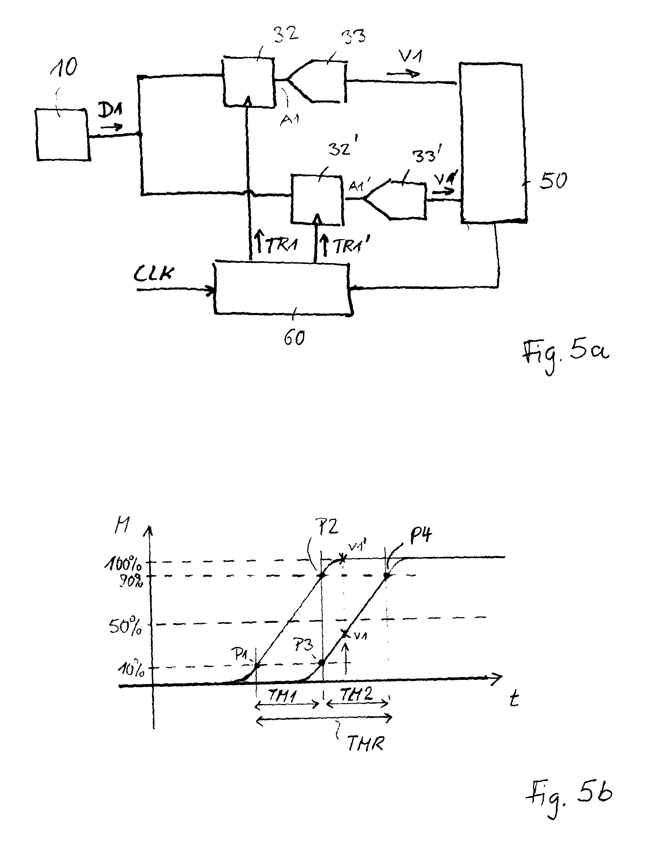

As described above, the trigger time points must be chosen such that the signal is sampled within its transition areas. In order to enhance the corresponding trigger time range, a filter showing a linear phase response might be connected between a data input and a corresponding sampling circuit. This filter decreases the (absolute) gradient of the signal edges without influencing further timing characteristics, e.g. the jitter properties, of the data signal. An alternative extension of the measurement or trigger time range that might be applied instead of such filter or in combination with such filter is described in Fig.5a.

Fig.5a shows a block diagram of a signal analyzer with an enhanced measurement range according to a further embodiment of the invention. By way of example, the signal analyzer shows a first and a second sample&hold circuit 32 and 32' with its outputs being connected to the input of each an analog-to digital converter 33 and 33' respectively. The outputs of the analog-to digital converters 33 and 33' are connected to a signal analyzing circuit 55.

Further, a trigger circuit 60 is provided that receives a clock signal CLK from a source, e.g. from the DUT 10 or any clock having the same frequency as the DUT or any frequency related to the data signal D1. The trigger circuit 60 provides a first trigger pulse TR1 and a shifted trigger pulse TR1' to the trigger input of the first sample&hold circuit 32 and to the trigger input of the second sample&hold circuit 32' respectively. Not shown here, the trigger circuit further provides a corresponding converter trigger signal to the analog-to-digital converters 33 as described in the above figure.

The data signal D1 is provided (e.g. over an input buffer not shown here) in parallel to both the inputs of the first and a second sample&hold circuit 32 and 32'.that sample the actual data signal values A1 and A1' at the time points when receiving the first trigger pulse TR1 and the second trigger pulse TR1' respectively, whereby the time distance between both trigger signal is determined to be equal or shorter than the transition duration. The analog-to digital converters convert the received analog values A1 and A1' into digital value V1 and V1'. This digital data value is provided to the analyzing circuit 50 for further edge fitting. Therefore, the analyzing circuit 50 keeps stored one or a plurality of edge models, e.g. a rising edge models characterizing the rising edge and a falling edge model characterizing the falling edge. The edge models describe the expected signal value over the time of the respective data signal D1.

The analyzing circuit 50 selects one of the received digital values V1 and V1' and performs an edge time determination by fitting the selected digital value V1 or V1' to an edge model, thereby transforming a difference in magnitude between said detected signal value and a predefined signal value into a time difference values as described above.

The trigger circuit 60 generates the trigger pulses TR1 and TR1' with respect to the clock signal CLK at a defined distance to each other. The distance is preferably chosen to be equal to a measurement or trigger time range of a single transition. Fig.5b shows an example, wherein two signal edges are depicted at the trigger time distance TR1'-TR1. This time distance is chosen to be equal to the measurement range TM1 or TM2 of the transition. In the example shown here, the measurement range is chosen as time interval between each a 10% point P1 of the signal amplitude (i.e. the difference between the high level and the low level) and a 90% point P2 of the signal amplitude or between corresponding points P3 and P4 of the delayed transition correspondingly. This allows for multiplying the resulting measurement range TMR by two. Providing further additional sample&hold circuits connected in parallel to the first and a second sample&hold circuit 32 and 32' allows for extending the resulting measurement range corresponding to the number of the sample&hold circuits.

As consequence, there will be only one of the values V1 or V1' that can be used for edge fitting whereby the other value will have the high level value or low level value or a value close to these values. In the example shown here, the first sample&hold circuit 32 derives a sample value V1 of roughly 40% of the signal amplitude, whereas the value V1' derived from the delayed measurement by the second sample&hold circuit32' shows almost the maximum level. Whereas the first value V1 can be well used for an edge fitting, the value V1' cannot be used for such edge fitting. Therefore, before the edge fitting, the analyzing circuit might chose the most significant value (i.e. the value that is not close or equal to the low or high signal level or the value that refers to the higher absolute gradient of the signal edge).

Alternatively, the signal analyzer might comprise a first and a second sampling path comprising each one sample&hold circuit and one switchable transfer gate. The transfer gates are alternately triggered in order to alternately provide the first sampled value and the second sampled value to one analog-to-digital converter. Similarly to the previous embodiment, the analyzing circuit receives the analog values V1 and V1' for further processing.

For determining a time interval between two signal edges, for each edge, the time distance between the corresponding time points of the fitted detected signal value and of a predefined transition value, e.g. the center value at a 50% level between the "low" bit signal level and a "high" bit signal level is determined. From the time difference values determined for two edges of a signal interval and a known time difference between the corresponding first trigger and second trigger pulse, the analysing circuit 50 might determine a plurality of timing characteristics, e.g. signal jitter characteristics as described under Fig.3a - Fig3b.

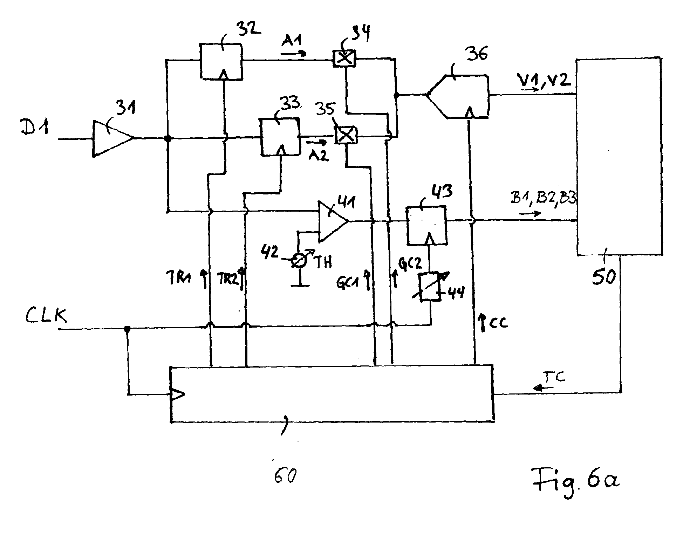

Fig. 6a shows an exemplary block diagram of a time interval analyzer. An analog sampling circuit comprises a first and a second sample&hold circuit 32 and 33 with its outputs being connected over each a first and second transfer gate 34 and 35 to the input of an analog-to digital converter 36. The data signal D1 is provided to an input of a buffer 31, that is connected to the inputs of both the first and a second sample&hold circuit 32 and 33.

Similar to the analyzer of Fig.1, the time interval analyzer comprises a digital sampling circuit for determining a bit history, the digital sampling circuit further comprising a comparator 41, a tunable threshold voltage source 42, a sampling flip flop 43, a tunable time delay circuit 44 and an analyzing circuit 50.

The data signal D1 is provided to a first input of the comparator 41. A second input of the comparator 41 is connected to the tunable threshold voltage source 42 that provides a tunable threshold voltage TH to said input. The output of the comparator 41 is connected to the data input of the sampling flip flop 43. The output of the sampling flip flop 43 is provided to the analyzing circuit 50. The trigger input of said sampling flip-flop 43 is connected to the tunable time delay circuit 44 that receives the clock signal CLK and provides a corresponding tuned trigger signal to the sampling flip flop 43.

The digital sampling circuit measures the position is determined by a relative time set by the delay circuit 44 with respect to corresponding transition of the clock signal CLK and the threshold value TH.

A trigger circuit 60 receiving the clock signal CLK provides a first trigger pulse TR1 to the first sample&hold circuit 32, a second trigger pulse TR2 to the second sample&hold circuit 33, a first and a second gate trigger or control signal SG1 and SG2 provided to the control input of the first and second transfer gate 34 and 35 respectively and a converter control signal CC to the analog-to-digital converter 36.

As being described previously, the analog sampling might be performed at timing points not being related to the data content of the data signal, The corresponding first sample values V1 and V2 and second sample values B1, B2, B3,..., are stored with relation to each other in or by the analyzing circuit 50. In a post processing, the first sample values are sorted with respect to a certain bit history into different bins.

In order to derive non-data dependent jitter characteristics, only time difference values of one pairs of bins might be used for the time interval analysis.

In a further embodiment, the relevant number of history bits might be derived my means of an algorithm described under Fig.4.

. The number of bits to be part of the transition history might be a fixed number or a selectable number being selected by the user or being automatically determined by the analyzer.

In order to determine a number of preceding subsequent bits influencing an actual transition the trigger circuit similar to Fig.1 might be adapted for continuously determining transition values V1 of all bit transitions or a subset of bit transitions (e.g. all rising edges within one test sequence) of the data signal D1. At the same time the digital bit sequence B1, B2, B3 being received from the sample flip flop 43 is received and related to the transition values V1. The analyzing circuit 50 might then assign to each first sample value V1 being sampled by the analog sampling circuit path a defined number of preceding bits B1, B2, B3, being sampled in the digital sampling circuit.

In a further embodiment, the signal analyzer automatically determines the number of bits according to the history characteristics of the data signal D1 as described under Fig.4.

If the bit sequence of the data signal D1 is known, or in other words, if the data signal D1 is known in principle, such sequence might be assigned to the sampled values V1 directly without digital sampling. In this case it is sufficient to digitally sample at specific times in order to synchronize to the data signal D1.

Fig. 6b shows a variant of Fig.6a comprising two analog-to digital converters 36a and 36b each connected to one of the sample and hold circuits 32 and 33. It is therefore not necessary to provide any transfer gate 34 or 35 to alternately provide the first signal sample A1 and the second signal sample A2 to a converter circuit. This allows for processing higher speed data as the two converter circuits work in parallel. Further, the accuracy is increased, as no transfer gates are comprised that could introduce errors.

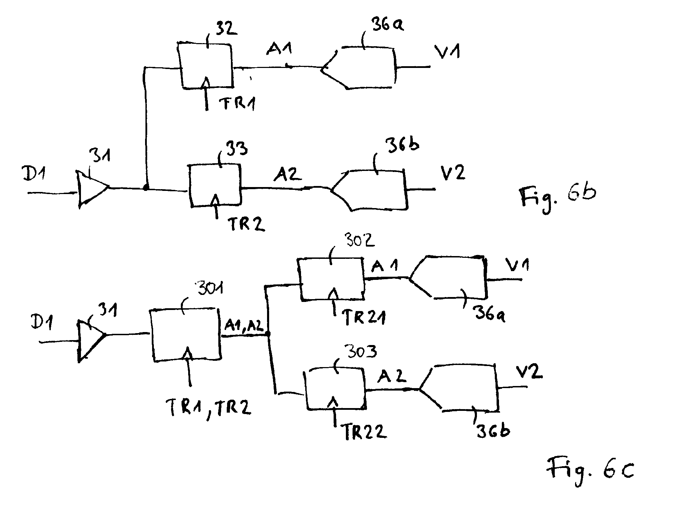

Fig.6c shows a variant of Fig.6b with a sampling circuit comprising a first sample&hold circuit 301 being arranged to receive the first trigger pulse TR1 and the second trigger pulse TR2 at its trigger input and the data signal D1 at its signal input, and exemplarily a second and a third sample&hold circuit 302 and 303 each receiving at their signal inputs a signal output from the first sample&hold circuit 301 The trigger circuit 60 alternately provides a third and a forth trigger pulse TR21 andTR22 to each one of the trigger inputs of said third and fourth sample&hold circuit 302 and303.

High bandwidth first sample&hold circuits allow for precise sampling with little signal deterioration. However, such high bandwidth sample&hold circuits may have short hold times. In this embodiment, only one sample&hold circuit 301 need to have highest bandwidth, whereas sample&hold circuit 302 and 303 might show lower bandwidths, and can be optimized for longer hold times. As a further advantage, the input signal has a smaller load impact compared to the above embodiment.

Further, as two analog-to-digital converters 36a and 36b are comprised, they might have a lower frequency (i.e. a lower conversion rate) with respect to the one analog-to-digital converter 36 of Fig.6a, or the circuit might process twice as many samples.

In a further embodiment, additional sample&hold circuits connected in parallel to the sample&hold circuits 302 and 303 are provided further allowing to reduce the conversion rates of the corresponding analog-to-digital converters, or to increase the processing rate correspondingly.

Fig.2a shows a first diagram with the signal magnitude A of a non-return-to-zero (NRZ) data signal over the time t. The data signal exemplarily comprises a bit sequence "01001" within the bit cycles 1-5. By way of example the low signal level AL representing a "0" bit equals zero. Therewith, the 50% level between said low signal level AL and the high signal level AH representing a "1" equals AH/2.

Exemplarily, a first time interval TM1 between a rising signal edge E1 and a falling signal edge E2 of the second bit is determined. The data signal is sampled at a first sample time T1 obtaining a corresponding first signal sample A1 and at a second sample time T2, obtaining a corresponding second signal value A2. These values are fitted to a rising edge model EM1 and a falling edge model EM2 respectively. The edge models EM1 and EM2 describe the edge characteristics of the data signal D1. From the difference in magnitude between the first sampled value A1 and a center value at the 50% signal level, and the second sampled value A2 and the center value at the 50% signal level, the time differences or deviations Δt1 and ΔT2 for each the rising edge and the falling edge respectively are determined. As the difference between the first sample time T1 and the second sample time T2 corresponds to the bit cycle time T, the time interval TM1 is obtained by subtracting the rising edge time deviation Δt1 from the cycle time T and adding the falling edge time deviation ΔT2 thereto.

Fig.2b shows a variation of a measurement of Fig.1 for a multi cycle time interval TM2. The data signal exemplarily comprises a third rising edge between the first and the second bit cycle and a fourth rising edge between the n-th bit cycle and the (n+1)-th bit cycle. Corresponding to Fig.2a, third and forth time differences ΔT3 and ΔT4 for both rising edge are determined and the difference between both edges is determined by subtracting the third time deviation ΔT3 from the n-cycle time nT and adding the fourth time difference ΔT4 thereto.

Fig. 3a shows a schematic diagram with a first distribution DE1 of all rising edge times and a second distribution DE2 of all falling edge times over the time t as result of repeated measurements at each one bit with the same bit history, e.g. at each the same position within the repeated test bit pattern or with a same history of a defined length as described above. The test bit pattern might be a pseudo random bit sequence of length 2¹⁵ -1 being repeated 1000 times. For both distribution DE1 and DE2, mean values M1 and M2 are determined. The difference between the mean values M1 and M2 denotes a so-called duty cycle distortion (DCD) of the data signal.

Fig.3b shows a schematic diagram with a third distribution DER of a bit interval TM1 again as result of repeated measurements at each one bit with the same bit history. As the cycle time T is constant, the variation of the bit interval equals the variation of the difference between the time differences Δt1 and ΔT2. The difference between a maximum bit interval MAX and a minimum bit interval MIN denotes the peak-to-peak value of the cycle-to cycle jitter. If only bits with the same bit history are measured, this value does not comprise data dependent jitter DDJ, but random jitter and periodic jitter.

As alternative, all bit interval of a repeated test sequence might be measured regardless the bit history. In this case, the difference between a maximum bit interval MAX and a minimum bit interval MIN denotes a peak-to-peak value the cycle-to cycle overall jitter including data dependent jitter DDJ. The data dependent jitter DDJ might be determined by taking the difference between this measurement and the measurement above, wherein only bits with the same history are measured.

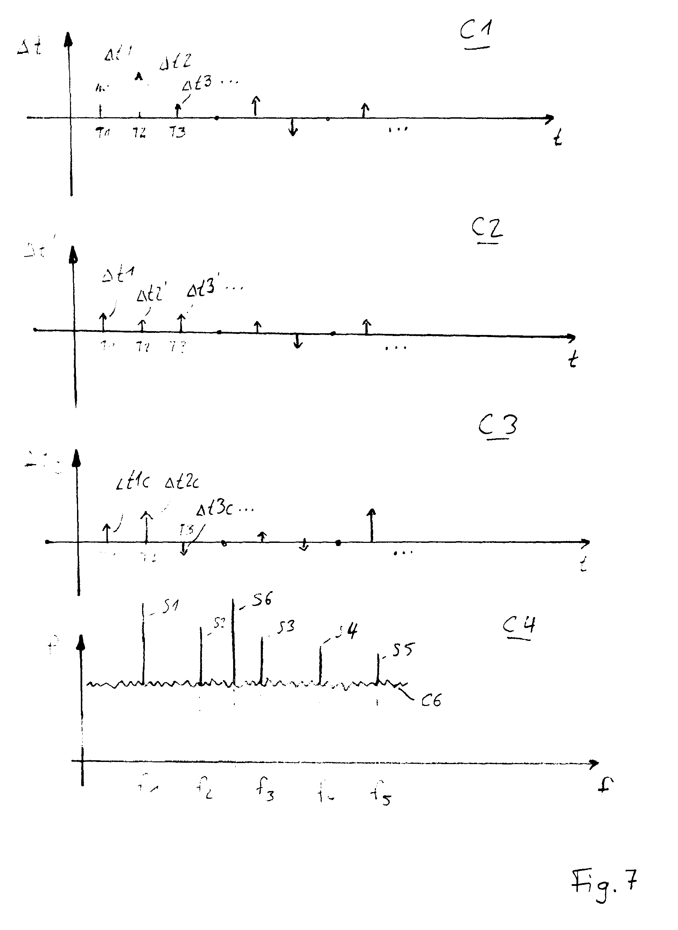

Fig.7 shows schematic diagrams describing a jitter separation with bit history consideration that might be performed in signal analyzers 50 of Fig.1 or Fig.6a-c.

In a first diagram C1, time difference values Δt1, Δt2, Δt3 are obtained from sample values at subsequent time points T1, T2, T3 in transition areas of the data signal D1. The values are obtained for transitions with different bit histories. Therefore, a jitter analysis of these values will include data dependent jitter.

In a second diagram C2, mean time difference values Δt1', Δt2', Δt3' are depicted that relate to the mean time differences M1, M2, M3,..., .(e.g. obtained by a measurement according to Fig.4) related to the different bit histories of the sampled values.

In a third diagram C3, adjusted difference values Δt1c, Δt2c, Δt3c are depicted that result from taking the differences Δt1 - Δt1', Δt2- Δt2', Δt3- Δt3' between each the time differences values and the mean time difference values. A jitter analysis of these values will not comprise data dependent jitter, but still comprises random jitter and periodic jitter.

For further decomposition, a Discrete Fourier Transition, preferably a Fast Fourier Transformation of the adjusted time difference values Δt1c, Δt2c, Δt3c might be performed, thereby obtaining a power density spectrum P over the frequency f. If periodic jitter is present, this spectrum will show one or more distinct frequency lines.

Providing a spectral jitter analysis the jitter components can be detected, e.g. the periodic jitter component can be derived by transforming the identified one or more distinct spectral components into the time domain.

C4 shows an exemplary of power density spectrum derived from a Discrete Fourier Transformation of the adjusted time difference values Δt1 c, Δt2c, Δt3c, thereby obtaining a power density spectrum P comprising by way of example peak frequencies S1- S6 referring to periodic jitter and roughly constant function over the frequency C6 referring to random jitter. By way of example, the frequency peaks S1- S5 are equidistantly spaced at exemplary frequencies f1- f5.

Instead of analyzing a single ended ground referenced signal D1, this signal might be received as a differential signal being transmitted over a differential line. The differential signal might de terminated by an input buffer that generates a ground referenced signal out of the differential signal. Alternatively, the input buffer, sample&hold circuit(s), and/or the analog-to-digital converter(s) of the above embodiments might be realized as differential signal circuits.

## Claims

1. A signal analyzer for determining characteristics of a data signal (D1) comprising a bit sequence of a plurality of bits, comprising:
a first sampling circuit (30) adapted for taking first sample values (A1) from the data signal (D1) in response to a first trigger signal (TR1, TR2),
a trigger circuit (60) adapted for providing the first trigger signal (TR1, TR2) in response to a clock signal (CLK) related to the data signal (D1), and
an analyzing circuit (50) adapted for providing a signal analysis based on the sample values (A1) received from the first sampling circuit (30) in conjunction with bit values (B1, B2, B3) of the data signal in a certain time range with respect to the first trigger signal.

2. The signal analyzer of claim 1, further comprising a second sampling circuit (40) adapted for receiving a second trigger signal (TS1, TS2) in response to the clock signal (CLK), comparing in response to said second trigger signal the data signal (D1) with a threshold (VTH) and assigning, in response to a second signal trigger signal (TS1, TS2) the bit values (B1, B2, B3) as result a corresponding comparison.

3. The signal analyzer of claim 2, wherein the trigger circuit (60) is adapted for providing the first trigger signal having trigger pulses (TR1, TR2) within time regions of transitions of the data signal (D1) and providing the second trigger signal having trigger pulses (TS1, TS2) within regions between signal transitions.

4. The signal analyzer of claim 1 or any one of the above claims, wherein the analyzing circuit (50) is adapted for storing an edge model (EM1, EM2) of signal edges (E1, E2, E3, E4) of the data signal (D1) describing a signal magnitude over time within a transition region, and determining from said edge model first time differences (Δt1) between first sample values (A1) and a defined transition value.

5. The signal analyzer of claim 4, wherein the defined signal value represents one of: the geometric center with respect to time of the edge model (EM1, EM2), the geometric center with respect to magnitude of the edge model (EM1, EM2) and the most likely transition point.

6. The time interval analyzer (2, 2', 6) of claim 4 or 5, wherein the edge model (EM1, EM2) represents one of:
a polynomial best fit curve of a measured signal edge (E1, E2, E3, E4),
a section-wise curve composed of one or more linear or polynomial sections,
a curve based on a plurality of measured edge curves (E1, E2, E3, E4),

7. The signal analyzer of claim 1 or any one of the above claims, wherein the first sampling circuit (30) comprises an analog-to-digital converter (23, 36) for converting said first sample values (A1) into multi-bit digital values (V1).

8. The signal analyzer of claim 7, wherein the analyzing circuit (50) is adapted to store the multi-bit digital values (V1) and the bit values (B1, B2, B3), thereby assigning to each multi-bit digital values (V1) a defined number of subsequent bit values (B1, B2, B3), wherein a set of subsequent bits represents at least partly a history sequence within the data signal (D1) occurred in advance to a corresponding assigned multi-bit digital value (V1).

9. The signal analyzer of claim 8, wherein the analyzing circuit (50) is adapted for sorting multi-bit digital values (V1) according to each their bit history, into a plurality of different groups, each group being related to a unique bit history represented as digital sequence of a defined number of bits.

10. The signal analyzer of claim 9, further being adapted for repetitively determining the first time differences (Δt1) for a plurality of different signal transitions within the data signal (D1), and determining for each bit history a mean value (M1, M2, M3, M4) of variations of the first time differences (Δt1).

11. The signal analyzer of claim 9 or 10, further being adapted for determining non data dependent jitter characteristics of the data signal (D1) by analyzing a distribution of variations of the first time differences (Δt1) related to a group of measurements having the same bit history.

12. The signal analyzer of claim 10, further being adapted for determining non data dependent jitter characteristics of the data signal (D1) by analyzing a distribution of variations of the first time differences (Δt1) related to a plurality of groups having different bit histories by taking into account the determined mean values (M1, M2, M3, M4).

13. The signal analyzer of claim 10, further being adapted for determining a sequence of first time difference values (Δt1, Δt2, Δt3) on the base of first sample values obtained by the first sampling circuit (30), determining a corrected sequence (Δt1', Δt2', Δt3') by subtracting from each first time difference value (Δt1, Δt2, Δt3) the mean value (M1, M2, M3, M4) relating to the bit history of the corresponding first time difference value, providing a time-to-frequency conversion of the corrected sequence, and detecting distinct lines (S1, S2, S3, S4, S5, S6) within the corresponding spectrum.

14. The signal analyzer of claim 8 or any one of the above claims, further being adapted for analyzing the first time difference values (Δt1) in order to determine a number of preceding subsequent bits influencing an actual bit, and to determine the defined number of subsequent bit values therefrom.

15. The signal analyzer of claim 14, further being adapted for setting the defined number of bits to a first value, deriving mean values (M1, M2, M3, M4) related to different bit histories, analyzing a time distance (TD1, TD2, TD3) between selected mean values, and incrementing the number of bits, if the time distance exceeds a defined maximum value.

16. The signal analyzer of claim 1, or any one of the above claims, wherein the control circuit (60) is further adapted for generating a first trigger signal with first trigger pulses (TR1) within a first region of a first signal transition (E1, E3) and a second trigger pulses (TR2) being delayed with respect to the first trigger pulses (TR1) by one or a plurality bit cycles of the first data signal (D1), and wherein the analyzing circuit (50) is further adapted for determining time interval values (TM1, TM2) between signal transitions of the first data signal (D1) based on pairs of sample values (A1, A2) related to pairs of first and second trigger pulses (TR1, TR2).

17. The signal analyzer of claim 1, or any one of the above claims, wherein the control circuit (60) is further adapted for generating a first trigger signal with first trigger pulse (TR1) and a second trigger pulse (TR1') being delayed with respect to the first trigger pulse (TR1) by a defined time distance chosen to be smaller or equal to a time duration of a signal transition of the first data signal (D1), taking corresponding pairs of first sample values (A1, A1') and choosing each a most significant sample value out of each pair for further analysis.

18. A method of determining characteristics of a data signal (D1) comprising a sequence of a plurality of bits, comprising:
providing a first trigger signal (TR1, TR2) in response to a clock signal (CLK) related to the data signal (D1),
providing first sample values (A1) from the data signal (D1), in response to the first trigger signal (TR1, TR2), and
providing a signal analysis based on the first sample values (A1) in conjunction with bit values (B1, B2, B3) of the data signal in a certain time range with respect to the first trigger signal.

19. A software program or product, preferably stored on a data carrier, for controlling an execution of the method of claim 18, when run on a data processing system such as a computer.
